(19) **Europäisches Patentamt European Patent Office Office européen des brevets**

(11) **EP 4 440 271 A1**

(12) **EUROPEAN PATENT APPLICATION**

(43) Date of publication:
**02.10.2024 Bulletin 2024/40**

(51) International Patent Classification (IPC):
**H05K 7/20** (2006.01)

(21) Application number: **23305473.3**

(22) Date of filing: **31.03.2023**

(52) Cooperative Patent Classification (CPC):
**H05K 7/20781**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **OVH**
**59100 Roubaix (FR)**

(72) Inventors:
• **BAUDUIN, Hadrien**
**59650 Villeneuve d'Ascq (FR)**

• **HNAYNO, Mohamad**
**59100 Roubaix (FR)**
• **VAHIDI FERDOUSI, Mahdi**
**59800 Lille (FR)**
• **CHEHADE, Ali**
**59283 Moncheaux (FR)**

(74) Representative: **BCF Global**
**Centre d'Entreprise et d'Innovation**
**17-21, rue Saint-Fiacre**
**75002 Paris (FR)**

Remarks:
Amended claims in accordance with Rule 137(2) EPC.

(54) **SERIALIZED LIQUID COOLING ARRANGEMENTS FOR DATACENTER SERVER RACKS**

(57)    A liquid cooling arrangement for cooling heat-generating components of a datacenter server rack is presented. The cooling arrangement includes a liquid cooling loop configured to convey a cooling liquid, a plurality of server clusters each server cluster having a plurality of server assemblies that incorporate at least one respective liquid cooling unit, and a plurality of heat exchangers fluidly connected to the liquid cooling units of the plurality of server clusters via the liquid cooling loop.

The heat exchangers configured to receive the heated cooling liquid discharged from the respective liquid cooling units and cool the received heated cooling liquid along with a pump fluidly coupled to the plurality of heat exchangers via the liquid cooling loop, wherein at least a portion of the liquid cooling loop comprises a serialized configuration that serially couples the server clusters and/or serially couples the server clusters and the heat exchangers.

**FIG. 1**

**Description**

**FIELD OF TECHNOLOGY**

The present technology relates to datacenter server rack configurations.

**BACKGROUND**

Datacenters are configured to house multitudes of server racks containing electronic equipment, such as computer systems (e.g., server assemblies), memory banks, etc. in efforts to process vast amounts of data in near real time. During operations, the electronic equipment of the server racks generates a significant amount of heat that must be dissipated in order to ensure continued efficient operation of the electronic equipment. Many cooling solutions have been implemented to address this heating issue, including the liquid cooling of heat-generating components by way of liquid cooling blocks directly mounted onto certain heat-generating components (often referred to as liquid or water block units).

Although water block units are capable of efficiently cooling the heat-generating components, their implementation in server racks typically requires a liquid distribution infrastructure to service the multitude of server racks and the vast number of electronic equipment supported therein. Such liquid distribution infrastructures conventionally require the use of relatively large and/or heavy piping conduit configurations and large capacity pumps to maintain the necessary liquid flow rates that supply the water blocks to service the cooling needs of the vast number of corresponding heat-generating components. It will be appreciated that the use of such piping conduit configurations and large pumps can be prohibitively costly for datacenters, in terms of initial investments and operating costs. Such piping conduit configurations and large pumps inherently occupy large footprints which may reduce a productivity (e.g. server per unit area of datacenter floor surface).

As a result, it appears to be desirable to provide a liquid cooling arrangement for datacenter server racks that can alleviate at least some of the cost prohibitive issues regarding conventional piping conduit configurations.

It is to be noted that the subject matter discussed in the background section should not be assumed to be prior art merely as a result of its mention in the background section. Similarly, the issues mentioned in the background section should not be interpreted as having been recognized in the prior art.

**SUMMARY**

It is an object of the present technology to alleviate at least some of the cost prohibitive issues that prevail in the prior art.

According to one aspect of the present technology, there is provided a liquid cooling arrangement for cooling heat-generating components of a datacenter server rack that includes a liquid cooling loop configured to convey a cooling liquid, a plurality of server clusters each server cluster having a plurality of server assemblies that incorporate at least one respective liquid cooling unit, and a plurality of heat exchangers fluidly connected to the liquid cooling units of the plurality of server clusters via the liquid cooling loop. The heat exchangers configured to receive the heated cooling liquid discharged from the respective liquid cooling units and cool the received heated cooling liquid along with a pump fluidly coupled to the plurality of heat exchangers via the liquid cooling loop, wherein at least a portion of the liquid cooling loop comprises a serialized configuration that serially couples the server clusters and/or serially couples the server clusters and the heat exchangers.

In some embodiments, the liquid cooling units of the server assemblies of the same server cluster are fluidly connected in parallel to one another.

In some embodiments, the server clusters are fluidly connected in series with one another and the heat exchangers are fluidly connected in parallel with one another.

In some embodiments, each of the server clusters is fluidly connected in series to a corresponding heat exchanger.

In some embodiments, the server clusters are fluidly connected in parallel with one another.

In some embodiments, the liquid cooling units of the server assemblies of a same server cluster are fluidly connected in series to one another.

In some embodiments, each of the server clusters is fluidly connected in series to a corresponding heat exchanger.

In some embodiments, the server clusters are fluidly connected in series with one another and the heat exchangers are fluidly connected in series with one another.

In some embodiments, the liquid cooling units of the server assemblies of a same server cluster are fluidly connected in series to one another.

In some embodiments, the server clusters are fluidly connected in series with one another and the heat exchangers are fluidly connected in series with one another.

According to another aspect of the present technology, there is provided a a liquid cooling arrangement for cooling heat-generating components of a datacenter server rack that comprises a liquid cooling loop configured to convey a cooling liquid, a plurality of server clusters, each server cluster including a plurality of server assemblies that incorporate at least one respective liquid cooling unit configured to collect at least a portion of a thermal energy generated by a heat-generating component of the server assembly, and a pump fluidly coupled to the liquid cooling units of the plurality of server clusters via the liquid cooling loop, the pump configured to convey the cooling liquid in the liquid cooling loop, wherein at least a portion of the liquid cooling loop comprises a serialized configuration that serially couples the server clusters.

In accordance with this other aspect, in some embodiments, the liquid cooling arrangement further comprises a plurality of heat exchangers fluidly connected to the liquid cooling units of the plurality of server clusters via the liquid cooling loop, the heat exchangers configured to receive the heated cooling liquid discharged from the respective liquid cooling units of the server assemblies and cool the received heated cooling liquid.

Additionally, in some embodiments, at least a portion of the liquid cooling loop comprises a serialized configuration that serially couples the server clusters and heat exchangers.

Implementations of the present technology each have at least one of the above-mentioned objects and/or aspects, but may not necessarily have all of them. It should be understood that some aspects of the present technology that have resulted from attempting to attain the above-mentioned object may not satisfy this object and/or may satisfy other objects not specifically recited herein.

Additional and/or alternative features, aspects and advantages of implementations of the present technology will become apparent from the following description, the accompanying drawings and the appended claims.

## BRIEF DESCRIPTION OF THE DRAWINGS

For a better understanding of the present technology, as well as other aspects and further features thereof, reference is made to the following description which is to be used in conjunction with the accompanying drawings, where:

FIG. 1 depicts a functional block diagram of a serialized liquid cooling arrangement for a datacenter server rack, in accordance with some non-limiting embodiments of the present disclosure;

FIG. 2 depicts a functional block diagram of an additional serialized liquid cooling arrangement for a datacenter server rack, in accordance with some non-limiting embodiments of the present disclosure;

FIG. 3 depicts a functional block diagram of a further serialized liquid cooling arrangement for a datacenter server rack, in accordance with some non-limiting embodiments of the present disclosure; and

FIG. 4 depicts a functional block diagram of another liquid cooling arrangement for a datacenter server rack, in accordance with some non-limiting embodiments of the present disclosure.

## DETAILED DESCRIPTION

The instant disclosure is directed to addressing at least some of the issues associated with conventional large/heavy piping conduit configurations that supply the liquid flows to the water blocks to adequately service the cooling needs of the vast number of corresponding heat-generating components. In particular, the instant disclosure presents various embodiments of serialized liquid cooling arrangements for server racks that facilitate the use of smaller, lighter, and streamlined piping conduit configurations.

The examples and conditional language recited herein are principally intended to aid the reader in understanding the principles of the present technology and not to limit its scope to such specifically recited examples and conditions. It will be appreciated that those skilled in the art may devise various arrangements that, although not explicitly described or shown herein, nonetheless embody the principles of the present technology.

Furthermore, as an aid to understanding, the following description may describe relatively simplified implementations of the present technology. As persons skilled in the art would understand, various implementations of the present technology may be of a greater complexity.

In some cases, what are believed to be helpful examples of modifications to the present technology may also be set forth. This is done merely as an aid to understanding, and, again, not to define the scope or set forth the bounds of the present technology. These modifications are not an exhaustive list, and a person skilled in the art may make other modifications while nonetheless remaining within the scope of the present technology. Further, where no examples of modifications have been set forth, it should not be interpreted that no modifications are possible and/or that what is described is the sole manner of implementing that element of the present technology.

Moreover, all statements herein reciting principles, aspects, and implementations of the present technology, as well as specific examples thereof, are intended to encompass both structural and functional equivalents thereof, whether they are currently known or developed in the future. Thus, for example, it will be appreciated by those skilled in the art that any block diagrams herein represent conceptual views of illustrative systems embodying the principles of the present technology.

With these fundamentals in place, we will now consider some non-limiting examples to illustrate the implementations of the various inventive aspects of the present disclosure.

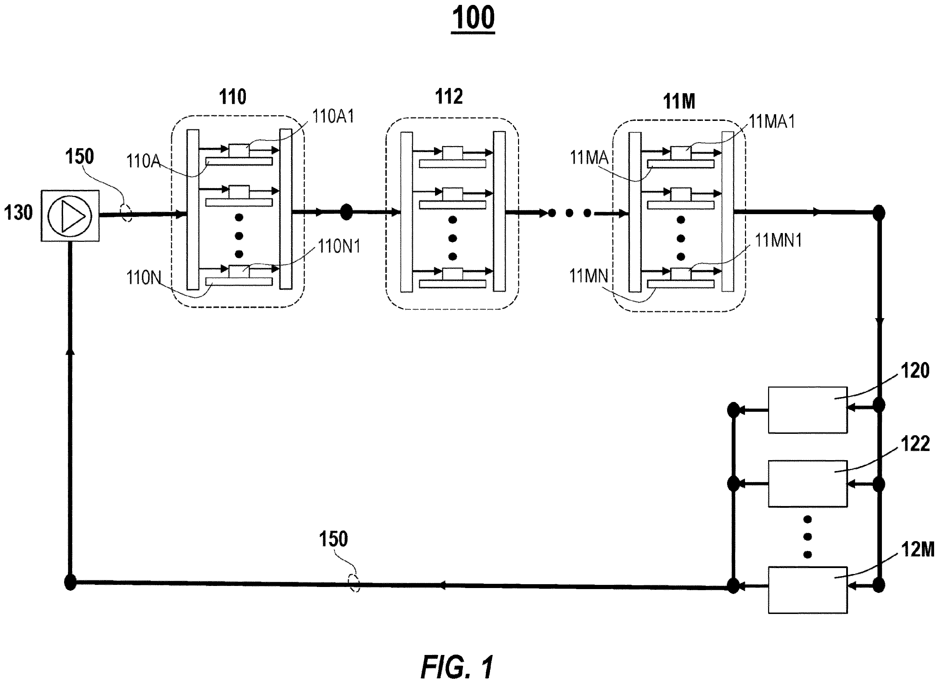

In particular, FIG. 1 depicts a functional block diagram of a server rack serialized liquid cooling arrangement **100**, in accordance with the embodiments of the present disclosure. As shown, liquid cooling arrangement **100** includes a plurality of server clusters **110, 112 ... 11M** that are fluidly connected in series to each other via a server rack liquid cooling loop **150**. The server rack liquid cooling loop **150** is configured to convey and facilitate the flow of a cooling liquid throughout the electronic equipment of the server rack and may be constructed from flexible materials (*e.g.,* rubber, plastic, *etc.),* rigid materials (*e.g.,* metal, PVC piping, *etc.),* or any combination of thereof. It will be appreciated that the conveyed liquid may include water, alcohol, or any suitable liquid capable of sustaining adequate cooling temperatures.

Each of the server clusters **110, 112 ... 11M** includes a plurality of server assemblies **110A-110N, 112A-112N ... 11MA-11MN** that are arranged in a parallel manner. As noted above, the server assemblies **110A-110N, 112A-112N ... 11MA-11MN** contain heat generating electronic components.

Accordingly, each of the parallel server assemblies **110A-110N, 112A-112N ... 11MA-11MN** incorporates at least one respective liquid cooling unit **110A1-110N1, 112A1-112N1 ... 11MA1-11MN1,** correspondingly arranged in parallel, for the direct thermal contact liquid cooling of the heat generating electronic components. That is, each of the liquid cooling units **110A1-110N1, 112A1-112N1 ... 11MA1-11MN1** is configured as liquid-cooled heat sink conduit block that is thermally coupled, either directly or indirectly, to the heat-generating electronic components, such that cooling liquid is circulated through internal liquid conduits of the liquid cooling units **110A1-110N1, 112A1-112N1 ... 11MA1-11MN1** to absorb the heat from the heat-generating electronic components and discharge the heated liquid therefrom.

For example, each one of the server clusters **110, 112 ... 11M** may include a first manifold that, in use, receives the cooling liquid and feeds the cooling liquid to the plurality of liquid cooling units of the server cluster in parallel. A second manifold may be provided downstream said plurality of liquid cooling units to receive the cooling liquid from the plurality of liquid cooling units.

The liquid cooling arrangement **100** further includes a plurality of air-to-liquid heat exchangers (ALHEXs) **120, 122 ... 12M** for cooling the cooling liquid. More specifically, in an implementation, each of the air-to-liquid heat exchangers (ALHEXs) **120, 122 ... 12M** defines an exchanger internal fluid conduit that forms a part of the cooling loop **150**. Therefore, each of the air-to-liquid heat exchangers (ALHEXs) **120, 122 ... 12M** has an inlet through which, in use, the cooling liquid flows into the exchanger internal fluid conduit, and an outlet through which, in use, the cooling liquid is discharged from the exchanger internal fluid.

The ALHEXs **120, 122 ... 12M** of the liquid cooling arrangement **100** are fluidly connected in parallel with one another. Namely, the internal fluid conduits of the air-to-liquid heat exchangers (ALHEXs) **120, 122 ... 12M** of the liquid cooling arrangement **100** are fluidly connected in parallel. The ALHEXs **120, 122 ... 12M** of the liquid cooling arrangement **100** are also fluidly coupled to server clusters **110, 112 ... 11M** via the liquid cooling loop **150**. The ALHEXs **120, 122 ... 12M** function to sufficiently air cool the heated liquid received by the liquid cooling units **110A1-110N1, 112A1-112N1 ... 11MA1-11MN1** for redirection back to the server clusters **110, 112 ... 11M**. The ALHEXs **120, 122 ... 12M** may embody any suitable configuration that reduces liquid temperatures through supplied air flow, such as, internal cooling coils, heat extracting air flow fins, *etc.* The ALHEXs **120, 122 ... 12M** may be, for example and without limitations, disposed on rear doors of a rack hosting the server clusters **110, 112 ... 11M**.

The liquid cooling arrangement **100** additionally includes at least one pump **130** that is fluidly connected to the server rack liquid cooling loop **150**. The pump **130** is configured to receive the cooling liquid from the ALHEXs **120, 122 ... 12M,** via the server rack liquid cooling loop **150**, and functions to forcibly provide the necessary circulatory flow rate of the cooling liquid through the server rack liquid cooling loop **150**, in order to service the liquid cooling units **110A1-110N1, 112A1-112N1 ... 11MA1-11MN1** of server clusters **110, 112 ... 11M**.

It is to be noted that the thermal power exchanged inside each cooling element of the server rack liquid cooling loop **150** capable of recovering or rejecting heat, including the liquid cooling units **110A1-110N1, 112A1-112N1 ... 11MA1-11MN1**, and the ALHEXs **120, 122 ... 12M**, as well as a group containing such cooling elements, including the server clusters **110, 112 ... 11M**, may be determined by the following relationship:

$$\mathbf{Q} = m \cdot C \cdot \Delta\mathrm{T}, \text{ in which:} \qquad\qquad (\text{Eq. 1})$$

Q represents the thermal power exchanged by forced convection;

m represents the fluid mass flow rate;

C represents the fluid specific heat capacity; and

$\Delta\mathrm{T}$ represents the difference between the temperatures of the fluid ingressing into the cooling element (*i.e.,* the liquid cooling units, or the ALHEXs) or the group (*i.e.,* the server clusters) and the fluid egressing out of the cooling element or the group.

It is to be noted that the relationship of Eq. 1 applied to the ALHEXs **120, 122 ... 12M** is valid for both air and liquid, and while neglecting any losses (e.g., by heat radiation), the thermal power exchanged by the liquid is equaled to the opposite number of the thermal power exchanged by the air. Thus, it exists a relationship between the liquid temperatures difference $\Delta\mathrm{T}_{liquid}$ and the air temperatures difference $\Delta\mathrm{T}_{air}$.

Another parameter of interest are the "pinch" values of the ALHEXs **120, 122 ... 12M**. That is, each of the ALHEXs **120, 122 ... 12M** operate in a counter current configuration and thus has a "hot side" and a "cold side". So, for the hot side, the pinch value $\Delta\mathrm{T}_{hotpinch}$ is defined as the difference between the temperature of the hot liquid entering the ALHEX to be cooled by and the temperature of the hot air exiting the ALHEX. And, for the cold side, the pinch value $\Delta\mathrm{T}_{coldpinch}$ is defined as the difference between the temperature of the cooled liquid exiting the ALHEX and the temperature of cooled fresh air entering the ALHEX. Both of the pinch values $\Delta\mathrm{T}_{hotpinch}$, $\Delta\mathrm{T}_{coldpinch}$ are positive numbers. A low pinch value $\Delta\mathrm{T}_{coldpinch}$ can benefit to the components to be cooled by the liquid cooling units **110A1-110N1, 112A1-112N1 ... 11MA1-11MN1**. During operations, depending on the thermal power exchanged and the liquid and air mass flow rates, pinch value $\Delta\mathrm{T}_{hotpinch}$ may act as a "limiting pinch" that affects or conditions negatively a lower value of the $\Delta\mathrm{T}_{coldpinch}$.

As indicated above, the liquid cooling arrangement **100** employs a configuration that combines serialized and parallelized liquid cooled components to achieve efficient circulatory flow rates and maintain adequate liquid cooling temperatures. As a general rule, liquid cooled components arranged in series, increase the fluid pressure drop in the liquid cooling loop **150** thereby inducing the pump **130** to operate at a lower flow rate. In contrast, liquid cooled components arranged in parallel, decrease the fluid pressure drop in the liquid cooling loop **150** thereby allowing the pump **130** to operate at a higher flow rate. Regarding the usual hydraulic characteristic curve of the pump **130**, arranging the liquid cooled components in series will more likely increase the flow rate inside each of them, in comparison to the local flow rate reachable in a similar loop where the liquid cooled components are arranged in parallel, and the global flow rate is distributed between each parallelized branch. In most similar applications, the preference is generally given to parallelized configuration of identical components, with, for example, parallelized server clusters **110, 112 ... 11M**, parallelized liquid cooling units **110A1-110N1, 112A1-112N1 ... 11MA1-11MN1**, parallelized ALHEXs **120, 122 ... 12M**, for different reasons, including the ease of maintenance and the uniformization of the operating points and thermal behavior for the identical components.

It is to be noted that as the liquid flow is circulated the through liquid cooling loop **150**, the ALHEXs **120, 122 ... 12M** may lose efficiency if their local liquid flow rate is reduced to a lower value. In an effort to achieve a balance between maintaining ALHEX efficiency and providing suitable circulatory flow rates, reference is made to the $\Delta\mathrm{T}$ indicating the fluid temperature differences between the input and output sides of the serialized server clusters (see, Eq. 1), from the input of the first server cluster **110** to the output of the last server cluster **11M**, as well as the pinch values $\Delta\mathrm{T}_{hotpinch}$, $\Delta\mathrm{T}_{coldpinch}$, and the temperature differences on the ALHEXs $\Delta\mathrm{T}_{liquid}$, $\Delta\mathrm{T}_{air}$, noted above.

In particular, as the circulatory liquid flow rate on the liquid input side of the ALHEX is lowered, $\Delta\mathrm{T}_{liqid}$ between the liquid input and output of the ALHEX increases until it becomes closer to the $\Delta\mathrm{T}_{air}$ between the air output and input on the air side of the ALHEX. In so doing, $\Delta\mathrm{T}_{hotpinch}$ is no longer limiting and the value of $\Delta\mathrm{T}_{coldpinch}$ is reduced along with the minimum temperature of the liquid cooling loop **150**. Meanwhile, by virtue of the serial connection of the server clusters, $\Delta\mathrm{T}$ for the heating of the liquid in the cooling loop **150** is increased, as it represents the sum of each elevation of liquid temperatures of each server clusters **110, 112 ... 11M**. During operations, the cooling loop **150** alternates between transient thermal states and thermal steady state, where the cooling of the liquid in the cooling loop **150** (weighted-average of all the individual $\Delta\mathrm{T}_{liquid}$) is equalled to $\Delta\mathrm{T}$.

Keeping these operational parameters in mind, as depicted in FIG. 1, liquid cooling arrangement **100** employs a configuration in which each of the serialized server clusters **110, 112 ... 11M** respectively incorporates multiple server assemblies **110A-110N, 112A-112N ... 11MA-11MN** arranged in a parallel manner. By internally arranging server clusters **110, 112 ... 11M** in series, the global circulatory flow rate (*i.e.,* global circulatory flow rate = circulatory flow rate before and after parallelization) is reduced. However, by connecting the server clusters **110, 112 ... 11M** respectively in series, the local circulatory flow rate to the liquid cooling units **110A1-110N1, 112A1-112N1 ... 11MA1-11MN1** is increased.

Moreover, for the ALHEXs **120, 122 ... 12M**, the circulatory flow rate is the distributed global flow rate, which is reduced. As the circulatory flow rate in the ALHEXs is lower, the cold side pinch and the minimal temperature of the cooling liquid circulating within the liquid cooling loop **150** are reduced.

Thus, in operation, the liquid cooling arrangement **100** provides for the pump **130** to convey the cooling liquid to the serially-coupled server clusters **110**, **112** ... **11M** via an increased local circulatory flow rate. In turn, the cooling liquid is conveyed, in a parallel manner, at an increased local circulatory flow rate in the liquid cooling units **110A1-110N1**, **112A1-112N1** ... **11MA1-11MN1** of each of the server clusters **110**, **112** ... **11M.**

As the cooling liquid successively flows through the server clusters **110**, **112** ... **11M**, it collects at least a portion of the thermal energy generated by the corresponding electronic equipment of each server cluster. However, the temperature of the cooling liquid remains within tolerable levels sufficient to continue to cool the electronic equipment until the cooling liquid is outputted by the last server cluster **11M**. The liquid outputted by the last server cluster **11M** is subsequently forwarded to the parallelized ALHEX **120**, **122** ... **12M**, at a reduced global circulatory flow rate, for cooling the cooling liquid prior to being redirected to the server cluster **110** by the liquid back to pump **130**.

In this manner, liquid cooling arrangement **100** provides a configuration that achieves a reduced global circulatory flow rate capable of efficiently cooling the electronic equipment contained within the server rack. As such, liquid cooling arrangement **100** allows for the use of different piping conduit configurations as well as pumps that are capable of effectively handling the reduced global circulatory flow rate, resulting in reduced costs of materials, equipment, and volume of cooling liquid required.

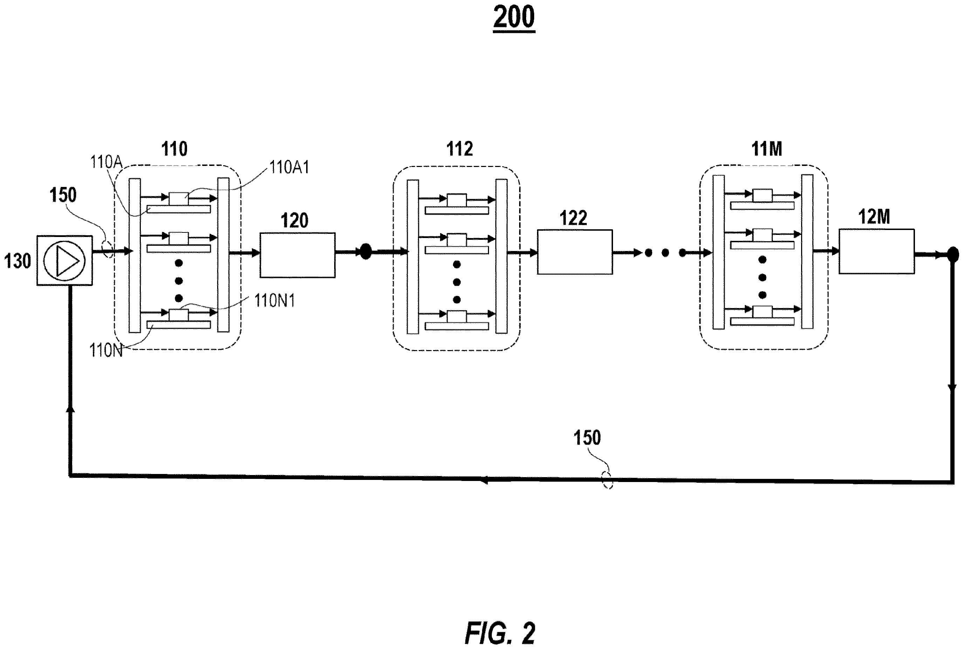

FIG. 2 depicts a functional block diagram of another server rack serialized liquid cooling arrangement **200**, in accordance with the embodiments of the present disclosure. Because the liquid cooling arrangement **200** contains similar components with like reference numerals as arrangement **100**, for the sake of brevity, detailed descriptions of such components will not be repeated unless necessary for the understanding of the embodiment.

As shown, the liquid cooling arrangement **200** includes a plurality of server clusters **110**, **112** ... **11M** and a plurality of ALHEXs **120**, **122** ... **12M** that are fluidly connected in series to each other via the server rack liquid cooling loop **150**. That is, each of the server clusters **110**, **112** ... **11M** is serially coupled to a corresponding ALHEX **120**, **122** ... **12M** via server rack liquid cooling loop **150**. As noted above, liquid cooling loop **150** conveys and facilitates the circulatory flow of cooling liquid throughout the electronic equipment of the server rack. More specifically, internal fluid conduits of the ALHEX **120**, **122** ... **12M** are fluidly connected in series with the server clusters **110**, **112** ... **11M,** the liquid cooling units of a same server cluster being fluidly connected in parallel.

Each of the server clusters **110**, **112** ... **11M** includes a plurality of server assemblies **110A-110N, 112A-112N** ... **11MA-11MN** containing heat-generating electronic components, that are arranged in parallel fashion within the server clusters **110**, **112** ... **11M**. In turn, each of the server assemblies **110A-110N, 112A-112N** ... **11MA-11MN** incorporates at least one respective liquid cooling unit **110A1-110N1, 112A1-112N1** ... **11MA1-11MN1** for direct thermal contact liquid cooling of the heat-generating components, in which the respective liquid cooling unit **110A1-110N1, 112A1-112N1** ... **11MA1-11MN1** are accordingly arranged in a parallel manner.

The ALHEXs **120**, **122** ... **12M** are configured to receive the heated cooling liquid from the liquid cooling units **110A1-110N1, 112A1-112N1** ... **11MA1-11MN1** of the respective server clusters **110**, **112** ... **11M,** via the server rack liquid cooling loop **150**. The ALHEXs **120**, **122** ... **12M** function to sufficiently air cool the heated liquid prior to forwarding the cooled cooling liquid to a succeeding server cluster **110**, **112 ... 11M**.

The liquid cooling arrangement **200** additionally includes at least one pump **130** that is fluidly connected to the server rack liquid cooling loop **150**. The pump **130** conveys the cooling liquid in the cooling loop **150**, and thus causes the cooling liquid to flow from the last serially-coupled ALHEX **12M** to the liquid cooling units **110A1-110N1, 112A1-112N1** ... **11MA1-11MN1** of server clusters **110**, **112 ... 11M**.

As such, liquid cooling arrangement **200** employs a configuration that combines serialized and parallelized components to achieve efficient circulatory flow rates and maintain adequate liquid cooling temperatures. In particular, by organizing the server clusters **110**, **112** ... **11M** and ALHEXs **120**, **122 ... 12M** in a serial configuration, the global circulatory flow rate of liquid cooling arrangement **200** is relatively reduced. In the meantime, by organizing the internal liquid cooling units **110A1-110N1, 112A1-112N1** ... **11MA1-11MN1** in a parallel configuration, the global circulatory flow rate is relatively increased. Finally, by combination of such serialization and parallelization, the global circulatory flow rate is reduced.

However, in operation, liquid cooling arrangement **200** provides for the pump **130** to convey the cooling liquid between the serially-coupled server clusters **110**, **112** ... **11M** and the ALHEXs **120**, **122 ... 12M** with local increased circulatory flow rates. In turn, the cooling liquid flows in the liquid cooling units **110A1-110N1, 112A1-112N1** ... **11MA1-11MN1** of each of the server clusters **110**, **112** ... **11M** at an increased local circulatory flow rate.

As the cooling liquid successively flows through the server clusters **110**, **112** ... **11M,** it collects at least a portion of the thermal energy generated by the corresponding electronic equipment of each server cluster. However, the cooling liquid is promptly cooled by a succeeding serially-coupled ALHEX **120**, **122 ... 12M** that, in turn, forwards the air-cooled liquid to a subsequent server cluster **110**, **112** ... **11M**. The air-cooled liquid outputted by the last ALHEX **12M** is then directed back to pump **130** for recirculation at a reduced global circulatory flow rate.

The liquid cooling arrangement **200** therefore provides a configuration in which, due to the serialization of liquid cooled components, the global circulatory flow rate is reduced while the local circulatory flow rate within the server clusters **110, 112 ... 11M,** the internal liquid cooling units **110A1-110N1, 112A1-112N1 ... 11MA1-11MN1,** and ALHEXs **120, 122 ... 12M** is increased.

In this manner, liquid cooling arrangement **200** achieves a reduced global circulatory flow rate capable of efficiently cooling the electronic equipment contained within the server rack. As such, liquid cooling arrangement **200** allows for the use of different piping conduit configurations as well as pumps that are capable of effectively handling the reduced global circulatory flow rate.

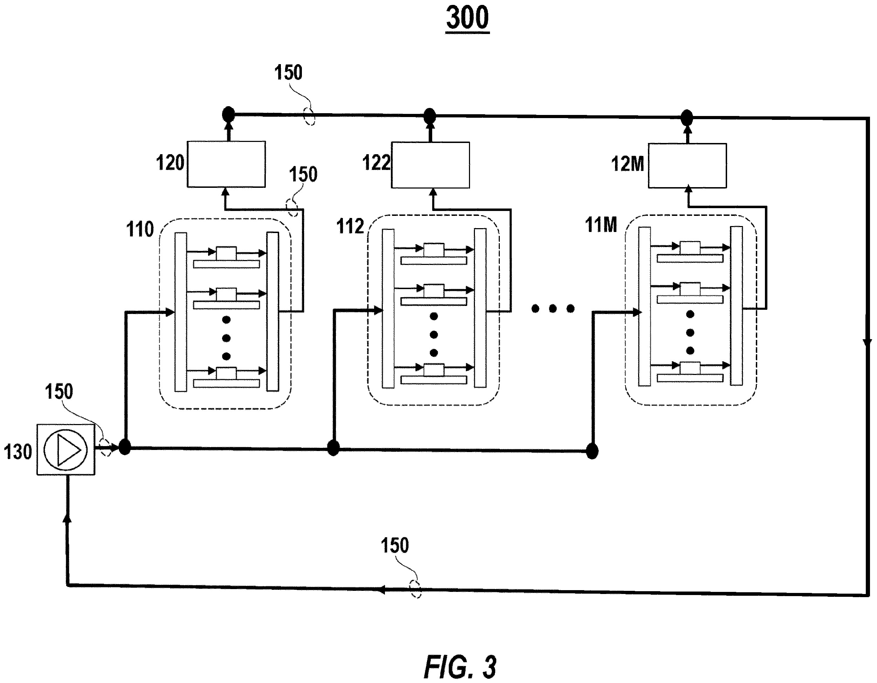

FIG. 3 depicts a functional block diagram of another server rack liquid cooling arrangement **300**, in accordance with the embodiments of the present disclosure. As shown, the liquid cooling arrangement **300** includes a plurality of server clusters **110, 112 ... 11M** that are each fluidly connected in series with a corresponding ALHEX **120, 122 ... 12M** via the server rack liquid cooling loop **150**. The combination of each server cluster **110, 112 ... 11M** serially coupled to a corresponding ALHEX **120, 122 ... 12M** are then arranged in a parallel manner via the liquid cooling loop **150**.

As noted above, each of the server clusters **110, 112 ... 11M** includes a plurality of server assemblies **110A-110N, 112A-112N** ... **11MA-11MN** incorporating at least one respective liquid cooling unit **110A1-110N1, 112A1-112N1 ... 11MA1-11MN1** that are fluidly connected in parallel with one another within the server clusters **110, 112 ... 11M**.

Moreover, the ALHEXs **120, 122 ... 12M** are configured to receive the heated cooling liquid from the liquid cooling units **110A1-110N1, 112A1-112N1 ... 11MA1-11MN1** of the respective server clusters **110, 112 ... 11M,** via the liquid cooling loop **150**. The ALHEXs **120, 122 ... 12M** function to sufficiently air cool the heated liquid prior to forwarding the cooled cooling liquid to a succeeding server cluster **110, 112 ... 11M**.

The liquid cooling arrangement **300** additionally includes at least one pump **130** that is fluidly connected to the server rack liquid cooling loop **150**. The pump **130** conveys the cooling liquid from the parallelized ALHEXs **120, 122 ... 12M,** via the server rack liquid cooling loop 150, and functions to forcibly provide the necessary circulatory flow rate of the cooling liquid through the server rack liquid cooling loop **150,** in order to service the liquid cooling units **110A1-110N1, 112A1-112N1 ... 11MA1-11MN1** of server clusters **110, 112 ... 11M**.

The liquid cooling arrangement **300** therefore provides a configuration in which the global circulatory flow rate is relatively reduced due to the serial connection of the server clusters **110, 112 ... 11M** with corresponding ALHEX **120, 122 ... 12M**. However, with the parallel connection of the server clusters **110, 112 ... 11M** and the parallel connection of the ALHEX **120, 122 ... 12M,** the global circulatory flow rate is increased. Finally, by combination of such serialization and parallelization, the global circulatory flow rate is increased. Moreover, with parallelization, the local circulatory flow rate within the server clusters **110, 112 ... 11M** and internal liquid cooling units **110A1-110N1, 112A1-112N1 ... 11MA1-11MN1** is reduced.

In this manner, liquid cooling arrangement **300** achieves an increased global circulatory flow rate capable of efficiently cooling the electronic equipment contained within the server rack. As such, liquid cooling arrangement **300** allows for the use of different piping conduit configurations as well as pumps that are capable of effectively handling the increased global circulatory flow rate.

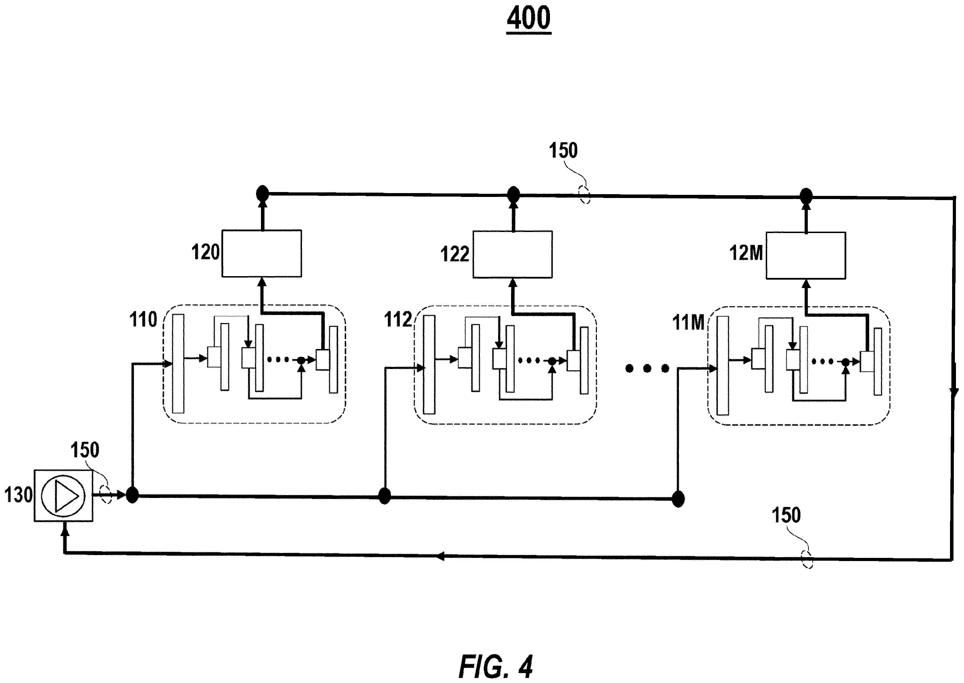

FIG. 4 depicts a functional block diagram of another server rack liquid cooling arrangement **400**, in accordance with the embodiments of the present disclosure. As shown, the liquid cooling arrangement **400** includes a plurality of server clusters **110, 112 ... 11M** that are each fluidly connected in series with a corresponding ALHEX **120, 122 ... 12M** via the liquid cooling loop **150**. The combination of each server cluster **110, 112 ... 11M** serially coupled to a corresponding ALHEX **120, 122 ... 12M** are then arranged in a fluidly coupled parallel manner via the liquid cooling loop **150**.

Each of the server clusters **110, 112 ... 11M** includes a plurality of server assemblies **110A-110N, 112A-112N** ... **11MA-11MN** that are arranged in serial fashion within the server clusters **110, 112 ... 11M**. In turn, each of the server assemblies **110A-110N**, **112A-112N** ... **11MA-11MN** incorporates at least one respective liquid cooling unit **110A1-110N1, 112A1-112N1 ... 11MA1-11MN1** for direct thermal contact liquid cooling that are accordingly arranged in a serial manner. That is, in each server cluster **110, 112 ... 11M,** the cooling liquid is supplied to a liquid cooling unit **110A1-110N1, 112A1-112N1 ... 11MA1-11MN1** that forwards the cooling liquid to a subsequent serial liquid cooling unit, in which the last liquid cooling unit forwards the liquid to the serially-coupled ALHEX **120, 122 ... 12M**. Moreover, within each of the server clusters **110, 112 ... 11M,** the server assemblies **110A-110N, 112A-112N ... 11MA-11MN** that are arranged in series may comprise groups of server assemblies that are fluidly connected in a parallel manner.

The parallel ALHEXs **120, 122 ... 12M** are configured to receive the heated liquid from the liquid cooling units **110A1-110N1, 112A1-112N1 ... 11MA1-11MN1** of the respective serially-coupled server clusters **110, 112 ... 11M,** via the server rack liquid cooling loop **150**. The ALHEXs **120, 122 ... 12M** function to sufficiently air cool the heated cooling liquid prior to forwarding the cooled liquid to the succeeding server clusters **110, 112 ... 11M.**

The liquid cooling arrangement **400** additionally includes at least one pump **130** that is fluidly connected to the server rack liquid cooling loop **150**. The pump **130** is configured to receive the cooling liquid from the parallelized ALHEXs **120, 122 ... 12M,** via the server rack liquid cooling loop **150**, and functions to forcibly provide the necessary circulatory flow rate of the air-cooled liquid through the server rack liquid cooling loop **150** in a parallel manner, in order to service the liquid cooling units **110A1-110N1, 112A1-112N1 ... 11MA1-11MN1** of server clusters **110, 112 ... 11M**.

Thus, in operation, liquid cooling arrangement **400** provides for pump **130** to supply air-cooled liquid to the parallelized combination of server clusters **110, 112 ... 11M** and serially-coupled ALHEXs **120, 122 ... 12M** via a reduced global circulatory flow rate. In turn, each of the server clusters **110, 112 ... 11M** supply air-cooled liquid to the serialized liquid cooling units **110A1-110N1, 112A1-112N1 ... 11MA1-11MN1** at an increased local circulatory flow rate.

The liquid cooling arrangement **400** therefore provides a configuration in which the global circulatory flow rate is reduced due to the serial connection of the server clusters **110, 112 ... 11M** with corresponding ALHEX **120, 122 ... 12M** and the local circulatory flow rate within the server clusters **110, 112 ... 11M** is reduced while the local circulatory flow rate of the internal liquid cooling units **110A1-110N1, 112A1-112N1 ... 11MA1-11MN1** is increased. Additionally, the local circulatory flow rate within the ALHEXs is also reduced.

In this manner, liquid cooling arrangement **400** provides a configuration that achieves a reduced global circulatory flow rate capable of efficiently cooling the electronic equipment contained within the server rack. As such, liquid cooling arrangement **400**

Modifications and improvements to the above-described implementations of the present technology may become apparent to those skilled in the art. The foregoing description is intended to be exemplary rather than limiting. The scope of the present technology is therefore intended to be limited solely by the scope of the appended claims.

**Claims**

1. A liquid cooling arrangement for cooling heat-generating components of a datacenter server rack, comprising:

   a liquid cooling loop configured to convey a cooling liquid;
   a plurality of server clusters, each server cluster including a plurality of server assemblies that incorporate at least one respective liquid cooling unit configured to collect at least a portion of a thermal energy generated by a heat-generating component of the server assembly;
   a plurality of heat exchangers fluidly connected to the liquid cooling units of the plurality of server clusters via the liquid cooling loop, the heat exchangers configured to receive the heated cooling liquid discharged from the respective liquid cooling units of the server assemblies and cool the received heated cooling liquid; and
   a pump fluidly coupled to the plurality of heat exchangers via the liquid cooling loop, the pump configured to convey the cooling liquid in the liquid cooling loop,
   wherein at least a portion of the liquid cooling loop comprises a serialized configuration that serially couples the server clusters and/or serially couples the server clusters and the heat exchangers.

2. The liquid cooling arrangement of claim 1, wherein the liquid cooling units of the server assemblies of a same server cluster are fluidly connected in parallel to one another.

3. The liquid cooling arrangement of claim 2, wherein the server clusters are fluidly connected in series with one another and the heat exchangers are fluidly connected in parallel with one another.

4. The liquid cooling arrangement of claim 2, wherein each of the server clusters is fluidly connected in series to a corresponding heat exchanger.

5. The liquid cooling arrangement of claim 4, wherein the server clusters are fluidly connected in parallel with one another.

6. The liquid cooling arrangement of claim 1, wherein the liquid cooling units of the server assemblies of a same server cluster are fluidly connected in series to one another.

7. The liquid cooling arrangement of claim 6, wherein each of the server clusters is fluidly connected in series to a corresponding heat exchanger.

8. The liquid cooling arrangement of claim 6, wherein the server clusters are fluidly connected in parallel with one another.

9. The liquid cooling arrangement of claim 6, wherein the server clusters are fluidly connected in series with one another and the heat exchangers are fluidly connected in series with one another.

10. The liquid cooling arrangement of claim 2, wherein the server clusters are fluidly connected in series with one another and the heat exchangers are fluidly connected in series with one another.

11. A liquid cooling arrangement for cooling heat-generating components of a datacenter server rack, comprising:

a liquid cooling loop configured to convey a cooling liquid;
a plurality of server clusters, each server cluster including a plurality of server assemblies that incorporate at least one respective liquid cooling unit configured to collect at least a portion of a thermal energy generated by a heat-generating component of the server assembly; and
a pump fluidly coupled to the liquid cooling units of the plurality of server clusters via the liquid cooling loop, the pump configured to convey the cooling liquid in the liquid cooling loop,
wherein at least a portion of the liquid cooling loop comprises a serialized configuration that serially couples the server clusters.

12. The liquid cooling arrangement of claim 11, further comprising a plurality of heat exchangers fluidly connected to the liquid cooling units of the plurality of server clusters via the liquid cooling loop, the heat exchangers configured to receive the heated cooling liquid discharged from the respective liquid cooling units of the server assemblies and cool the received heated cooling liquid.

13. The liquid cooling arrangement of claim 12, wherein at least a portion of the liquid cooling loop comprises a serialized configuration that serially couples the server clusters and heat exchangers.

**Amended claims in accordance with Rule 137(2) EPC.**

1. A liquid cooling arrangement (100, 200, 300, 400) for cooling heat-generating components of a datacenter server rack, comprising:

a liquid cooling loop (150) configured to convey a flow of a cooling liquid;
a pump (130) fluidly coupled to the liquid cooling loop (150) and configured to urge the flow of the cooling liquid conveyed by the liquid cooling loop (150);
a plurality of server clusters (110-11M) fluidly coupled to the liquid cooling loop (150), each server cluster (110-11M) including a plurality of server assemblies (110A-11MN) that incorporate at least one respective liquid cooling unit (110A1-11MN1) configured to collect at least a portion of a thermal energy generated by a heat-generating component of the server assembly; and
a plurality of heat exchangers (120-12M), in which each heat exchanger is fluidly connected in series to a respective server cluster, via the liquid cooling loop (150), the heat exchangers (120-12M) configured to receive the heated cooling liquid discharged from the liquid cooling units (110A1-11MN1) of the respective server clusters and cool the received heated cooling liquid for recirculation by the pump (130) and the liquid cooling loop (150),
wherein, all the server clusters fluidly connected in series to a respective heat exchanger are arranged in parallel relative to the liquid cooling loop (150).

2. The liquid cooling arrangement of claim 1, wherein the liquid cooling units (110A1-11MN1) of the server assemblies (110A-11MN) of a same server cluster are fluidly connected in parallel to one another.

3. The liquid cooling arrangement of claim 1, wherein the liquid cooling units (110A1-11MN1) of the server assemblies of a same server cluster (110-11M) are fluidly connected in series to one another.

4. The liquid cooling arrangement of claim 1, wherein the liquid cooling units (110A1-11MN1) of the server assemblies of a same server cluster (110-11M) are fluidly connected in parallel to one another.

5. A liquid cooling method for cooling heat-generating components of a datacenter server rack, comprising:

conveying a flow of a cooling liquid via a liquid cooling loop (150);
urging the flow of the cooling liquid conveyed by the liquid cooling loop (150) via a pump (130) fluidly coupled to the liquid cooling loop (150);
arranging a plurality of server clusters (110-11M) fluidly coupled to the liquid cooling loop (150), in which each server cluster (110-11M) includes a plurality of server assemblies (110A-11MN) that incorporate at least one respective liquid cooling unit (110A1-11MN1) configured to collect at least a portion of a thermal energy generated by a heat-generating component of the server assembly; and

serially fluidly-connecting each server cluster to one of a plurality of heat exchangers (120-12M) via the liquid cooling loop (150), the heat exchangers (120-12M) configured to receive the heated cooling liquid discharged from the liquid cooling units (110A1-11MN1) of the respective server clusters and cool the received heated cooling liquid for recirculation by the pump (130) and the liquid cooling loop (150),

wherein, each of the server clusters serially-connected to a respective heat exchanger are arranged in parallel relative to the liquid cooling loop (150).

6. The liquid cooling method of claim 5, further comprising arranging the liquid cooling units (110A1-11MN1) of the server assemblies of a same server cluster (110-11M) to be fluidly connected in a serial configuration to one another.

7. The liquid cooling method of claim 5, further comprising arranging the liquid cooling units (110A1-11MN1) of the server assemblies of a same server cluster (110-11M) to be fluidly connected in a parallel configuration to one another.

FIG. 1

200

FIG. 2

12M 11M 122 112 120 110 110A1 110A 110N 110N1 130 150

*FIG. 3*

**FIG. 4**

Europäisches
Patentamt

European
Patent Office

Office européen
des brevets

# EUROPEAN SEARCH REPORT

Application Number

EP 23 30 5473

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2020/253090 A1 (HUANG YEN-CHIA [TW] ET AL) 6 August 2020 (2020-08-06)<br>* figure 3 *<br>* paragraph [0018] *<br>————— | 1-13 | INV.<br>H05K7/20 |
| A | EP 4 142 443 A1 (OVH [FR]) 1 March 2023 (2023-03-01)<br>* figure 6 *<br>* paragraphs [0040] – [0042] *<br>————— | 1-13 | |
| A | EP 4 152 906 A1 (OVH [FR]) 22 March 2023 (2023-03-22)<br>* figure 3 *<br>* paragraphs [0051] – [0055] *<br>————— | 1-13 | |

TECHNICAL FIELDS
SEARCHED        (IPC)

H05K

The present search report has been drawn up for all claims

| Place of search | Date of completion of the search | Examiner |
|---|---|---|
| The Hague | 11 September 2023 | Galary, Grzegorz |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

........................................................................

& : member of the same patent family, corresponding document

EPO FORM 1503 03.82 (P04C01)

## EP 4 440 271 A1

### ANNEX TO THE EUROPEAN SEARCH REPORT
### ON EUROPEAN PATENT APPLICATION NO.

EP 23 30 5473

This annex lists the patent family members relating to the patent documents cited in the above-mentioned European search report.
The members are as contained in the European Patent Office EDP file on
The European Patent Office is in no way liable for these particulars which are merely given for the purpose of information.

11-09-2023

| Patent document cited in search report | | Publication date | Patent family member(s) | | Publication date |
|---|---|---|---|---|---|
| US 2020253090 | A1 | 06-08-2020 | TW | 202031114 A | 16-08-2020 |
| | | | US | 2020253090 A1 | 06-08-2020 |
| EP 4142443 | A1 | 01-03-2023 | CA | 3170605 A1 | 28-02-2023 |
| | | | CN | 115734531 A | 03-03-2023 |
| | | | EP | 4142443 A1 | 01-03-2023 |
| | | | KR | 20230032972 A | 07-03-2023 |
| | | | US | 2023062986 A1 | 02-03-2023 |
| EP 4152906 | A1 | 22-03-2023 | NONE | | |

EPO FORM P0459

For more details about this annex : see Official Journal of the European Patent Office, No. 12/82